(19) Europäisches Patentamt

European Patent Office

Office européen des brevets

(11) **EP 1 587 147 A2**

(12) **EUROPEAN PATENT APPLICATION**

(43) Date of publication:
**19.10.2005 Bulletin 2005/42**

(51) Int Cl.7: **H01L 29/861**, H01L 29/78,
H01L 29/165, H01L 27/07,
H01L 29/24

(21) Application number: **05007568.8**

(22) Date of filing: **06.04.2005**

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(30) Priority: **13.04.2004 JP 2004117567**

(71) Applicant: **NISSAN MOTOR CO., LTD.**
**Yokohama-shi Kanagawa-ken (JP)**

(72) Inventors:
• **Tanaka, Hideaki**
**Yokosuka-shi Kanagawa-ken (JP)**
• **Hoshi, Masakatsu**
**Yokohama-shi Kanagawa-ken (JP)**
• **Hayashi, Tetsuya**
**Yokosuka-shi Kanagawa-ken (JP)**

(74) Representative: **Grünecker, Kinkeldey,**
**Stockmair & Schwanhäusser Anwaltssozietät**
**Maximilianstrasse 58**
**80538 München (DE)**

(54) **Semiconductor device with heterojunction**

(57) An aspect of the present invention provides a semiconductor device that includes a semiconductor base essentially made of a first semiconductor material of a first conductivity type, a hetero-semiconductor region essentially made of a second semiconductor material whose band gap is different from that of the first semiconductor material, formed on the semiconductor base, and forming a heterojunction with the semiconductor base, a cathode electrode formed in contact with the semiconductor base, and an anode electrode formed in contact with the hetero-semiconductor region, wherein the first semiconductor material is a silicon-carbide (SiC) single crystal and the heterojunction is formed on a {0001-} crystal face of the silicon-carbide single crystal.

A further aspect of the present invention relates to the incorporation of the semiconductor device above into a power MOSFET.

A further aspect of the present invention relates to a vertical MISFET comprising a SiC drain/drift region forming a heterojunction with the channel region.

**FIG.1**

## Description

## BACKGROUND OF THE INVENTION

The present invention relates to a semiconductor device, and particularly, to a semiconductor device having a heterojunction.

A related art that forms a background of the present invention is Japanese Laid Open Patent Publication No. 2003-318413 (hereinafter referred to as "Patent Document 1"). A semiconductor device disclosed in the Patent Document 1 will be explained. This device includes a silicon carbide (hereinafter referred to as SiC) semiconductor base consisting of an n-type SiC substrate and an n-type SiC epitaxial layer whose impurity concentration is lower than that of the SiC substrate. On the semiconductor base, a hetero-semiconductor region is formed. The hetero-semiconductor region is made of an n-type silicon polycrystal serving as a second semiconductor material that forms a heterojunction with SiC and has a different band gap from SiC. In contact with the SiC substrate, a cathode electrode is formed. In contact with the hetero-semiconductor region, an anode electrode is formed.

When a voltage is applied between the anode electrode and the cathode electrode, a junction interface between the hetero-semiconductor region and the SiC epitaxial layer shows a rectifying action, i.e., a diode characteristic.

When the cathode electrode is grounded and a positive potential is applied to the anode electrode, the semiconductor device shows a conductive characteristic corresponding to a forward diode characteristic. When a negative potential is applied to the anode electrode, the semiconductor device shows a reverse diode characteristic. These forward and reverse characteristics resemble those of a Schottky junction consisting of a metal electrode and a semiconductor material.

According to the related art, the impurity concentration and conductivity type of the hetero-semiconductor region may be changed to provide desired reverse (and corresponding forward) diode characteristics. Compared with a diode with a Schottky junction, the related art is advantageous in adjusting diode characteristics to provide, for example, an optimum withstand voltage.

## SUMMARY OF THE INVENTION

The closer the crystallinity of the hetero-semiconductor region to a single crystal, the more the characteristics of the heterojunction provided by the related art improves. Namely, the reverse and forward characteristics of the related art are dependent on the impurity concentration and conductivity type of the hetero-semiconductor region. Forming a silicon single crystal or a silicon polycrystal composed of large grains on an SiC semiconductor substrate needs special expensive equipment such as a laser annealing apparatus or an MBE (molecular beam epitaxy) apparatus to increase the manufacturing cost of the semiconductor device. If the hetero-semiconductor region is formed without such special equipment or special processes, only a silicon polycrystal composed of fine grains will be formed on a {0001} crystal face of the substrate. A heterojunction formed with such silicon polycrystal will have limited characteristics. An object of the present invention is to solve this problem and provide a semiconductor device including a hetero-semiconductor region manufacturable at low cost and having large grains.

An aspect of the present invention provides a semiconductor device that includes a semiconductor base essentially made of a first semiconductor material of a first conductivity type, a hetero-semiconductor region essentially made of a second semiconductor material whose band gap is different from that of the first semiconductor material, formed on the semiconductor base, and forming a heterojunction with the semiconductor base, a cathode electrode formed in contact with the semiconductor base, and an anode electrode formed in contact with the hetero-semiconductor region, wherein the first semiconductor material is a silicon-carbide (SiC) single crystal and the heterojunction is formed on a {0001-} crystal face of the silicon-carbide single crystal.

Another aspect of the present invention provides a semiconductor device that includes a drain region formed from a semiconductor base made of a first semiconductor material of a first conductivity type, a base region of a second conductivity type, base region in contact with the drain region, a source region of the first conductivity type, the source region in contact with the base region, a source electrode formed in contact with the source region and the base region, a drain electrode formed in contact with the drain region, and a hetero-semiconductor region made of a second semiconductor material that has a different band gap from the first semiconductor material, forms a heterojunction with the drain region, and is in contact with the source electrode, wherein the first semiconductor material is a silicon-carbide single crystal and the heterojunction is formed on a {0001-} crystal face of the silicon-carbide single crystal.

Still another aspect of the present invention provide a semiconductor device that includes a semiconductor base essentially made of a first semiconductor material of a first conductivity type, a hetero-semiconductor region formed on the semiconductor base and essentially made of a second semiconductor material that has a different band gap from the first semiconductor material and forms a heterojunction with the semiconductor base, a gate electrode formed on a gate insulating film adjacent to the heterojunction between the semiconductor base and the hetero-semiconductor region, a source electrode formed in contact with the hetero-semiconductor region, and a drain electrode formed in contact with the semiconductor base, wherein the first semiconductor material is a silicon-carbide single crystal and the heterojunction is formed on a {0001-} crystal face of the silicon-carbide single crystal.

Furthermore, still another aspect of the present invention provides a semiconductor device that includes a semiconductor base made of a first semiconductor material of a first conductivity type, a hetero-semiconductor region formed on the semiconductor base and made of a second semiconductor material that has a different band gap from the first semiconductor material and forms a heterojunction with the semiconductor base, a trench formed through the hetero-semiconductor region to reach the semiconductor base, a gate electrode formed on a gate insulating film in the trench, a source electrode formed in contact with the hetero-semiconductor region, and a drain electrode formed in contact with the semiconductor base, wherein, the first semiconductor material is a silicon-carbide single crystal and the heterojunction is formed on a {0001-} crystal face of the silicon-carbide single crystal.

## BRIEF DESCRIPTION OF THE DRAWINGS

Figure 1 is a sectional view showing a semiconductor device according to a first embodiment of the present invention.
Figure 2A to 2C show the energy band structure of the conduction band according to the first embodiment of the present invention.
Figure 3 is a sectional view showing another semiconductor device according to a first embodiment of the present invention.
Figure 4 is a sectional view showing still another semiconductor device according to a first embodiment of the present invention.
Figure 5 is a sectional view showing still another semiconductor device according to a first embodiment of the present invention.
Figure 6 is a sectional view showing still another semiconductor device according to a first embodiment of the present invention.
Figure 7 is a sectional view showing still another semiconductor device according to a first embodiment of the present invention.
Figure 8 is a sectional view showing a semiconductor device according to a second embodiment of the present invention.
Figure 9 is a sectional view showing a semiconductor device according to a third embodiment of the present invention.
Figure 10 is a sectional view showing another semiconductor device according to a third embodiment of the present invention.
Figure 11 is a sectional view showing another semiconductor device according to a third embodiment of the present invention.
Figure 12 is a sectional view showing still another semiconductor device according to a third embodiment of the present invention.
Figure 13 is a sectional view showing still another semiconductor device according to a third embodiment of the present invention.
Figure 14 is a sectional view showing a semiconductor device according to a fourth embodiment of the present invention.

## DETAILED DESCRIPTION OF EMBODIMENTS

Embodiments of the present invention will be explained with reference to the accompanying drawings. The same or similar parts are represented with like reference marks through the drawings and the following description to avoid their repetitive explanations.

In the embodiments mentioned below, an SiC substrate 101 and an SiC epitaxial layer 102 are each made of a single crystal having a polytype of, for example, 4H, 6H, 15R, or the like that is called an " $\alpha$-SiC" polytype. The top side of each drawing corresponds to a {0001-} crystal face 200 as depicted in each drawing. "1-" in {0001-} indicates that a rightmost Miller index is "-1."

First embodiment

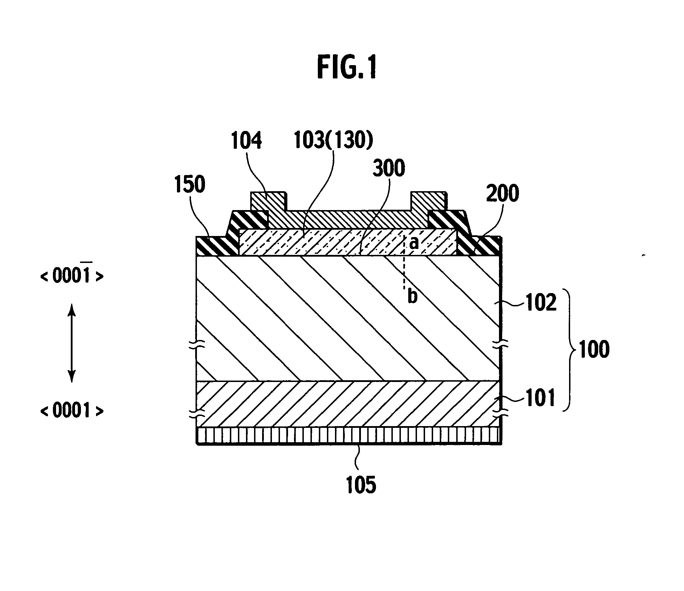

Figure 1 is a sectional view showing a semiconductor device according to a first embodiment of the present invention. An n-type (first conductivity type) SiC substrate 101 and an n-type SiC epitaxial layer 102 whose impurity concentration is lower than that of the substrate 101 form an SiC semiconductor base 100. The SiC substrate 101 has, for example, a specific resistance of several to several hundreds of in $\Omega \cdot cm$ and a thickness of several tens to several hundreds of $\mu m$. The SiC epitaxial layer 102 has, for example, an impurity concentration of $1 \times 10^{15}$ to $1 \times 10^{19}$ cm$^{-3}$ and a thickness of several to several tens of $\mu m$. On the SiC epitaxial layer 102, a hetero-semiconductor region 103 is formed from an n-type silicon polycrystal film 130. The silicon polycrystal of the film 130 is a second semiconductor material that forms a heterojunction 300 with SiC of the epitaxial layer 102 and has a different band gap from SiC. The heterojunction 300 is formed on a {0001-} crystal face 200 of the SiC semiconductor base 100. An interface of the heterojunction 300 forms an energy barrier. In contact with the SiC base 100, a cathode electrode 105 is formed. In contact with the hetero-semiconductor region 103, an anode electrode 104 is formed.

Operation of the semiconductor device according to the first embodiment will be explained in connection with an energy band structure of a conduction band between points "a" and "b" shown in Fig. 1. For the sake of explanation, it is assumed that the heterojunction 300 is formed between a silicon single crystal and an SiC single crystal.

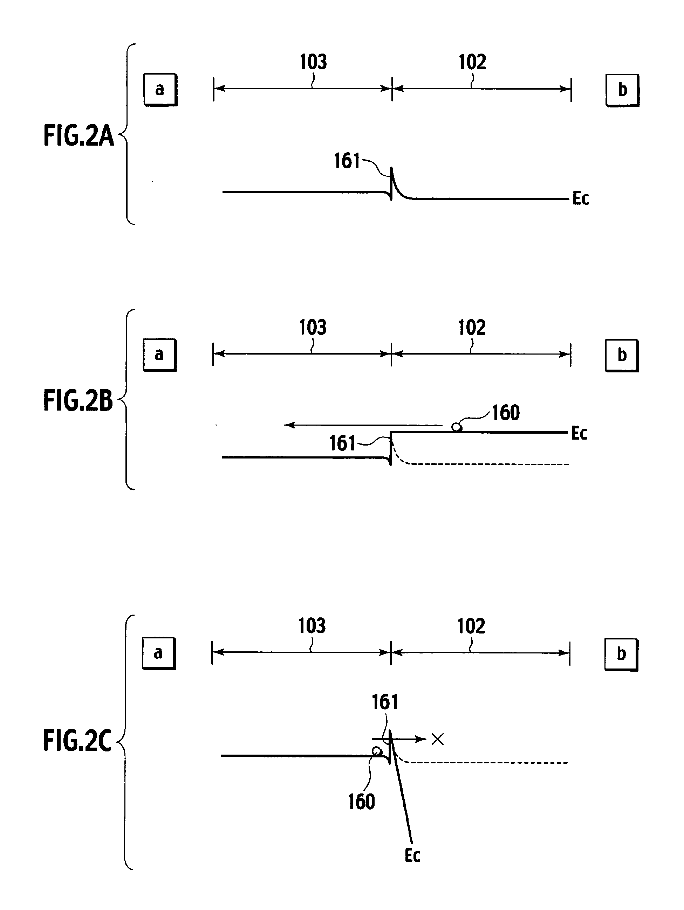

Figure 2A shows a thermal equilibrium state of the energy band structure of the conduction band with both the anode electrode 104 and cathode electrode 105 being grounded. When a positive potential is applied to the anode electrode 104 and a groud potential to the cathode electrode 105, the energy band structure of the conduction band changes to Fig. 2B. Under this state, electrons 160 flow from the SiC epitaxial layer 102 to the hetero-semiconductor region 103, and therefore, a current flows from the anode electrode 104 to the cathode electrode 105.

If the anode electrode 104 is grounded and a high voltage is applied to the cathode electrode 105, i. e., if the voltage is reversely applied, the energy band structure of the conduction band changes to Fig. 2C. Under this state, the interface of the heterojunction 300 produces a barrier 161 to block electrons 160, and this blocked state is maintained. In this way, the semiconductor device according to the first embodiment demonstrates forward and reverse diode characteristics.

The semiconductor device of the related art may also demonstrate the forward and reverse diode characteristics. However, the related art forms a hetero-semiconductor region (103) on a {0001} crystal face, and this hetero-semiconductor region will consist of fine silicon grains if it is formed without using special equipment such as a laser annealing apparatus or an MBE apparatus. The semiconductor device of the related art, therefore, hardly provides the heterojunction having the energy band structure shown in Figs. 2A to 2C. Namely, the heterojunction provided by the related art demonstrates unsatisfactory forward and reverse characteristics.

On the other hand, the first embodiment of the present invention employs a {0001-} crystal face having the lowest surface energy among the crystal faces of an SiC single crystal called $\alpha$-SiC when forming the hetero-semiconductor region 103. Compared with the related art, the hetero-semiconductor region 103 of the first embodiment includes larger silicon grains. As a result, the energy band structure of a conduction band of the heterojunction 300 of the first embodiment is substantially the same as that shown in Figs. 2A to 2C. Namely, the first embodiment can realize required forward and reverse characteristics determined by the impurity concentration and conductivity type of the hetero-semiconductor region 103 without special processes or special equipment such as a laser annealing apparatus or an MBE apparatus.

Forming the hetero-semiconductor region 103 on a {0001} crystal face will be explained. Generally, hetero-epitaxial growth is dependent on a surface energy balance at the interface of the heterojunction 300.

$$\sigma_S > \sigma_M + \sigma_I \qquad (1)$$

If this expression (1) is satisfied, a three-dimensional growth mode is achieved to grow island-like membranes. Each island membrane becomes a grain. In the expression (1), S is a substrate, M indicates a film, I indicates an interface, $\sigma_S$ indicates surface energy on the substrate, $\sigma_M$ is surface energy on the silicon polycrystal film 130, and $\sigma_I$ is surface energy at the interface of the heterojunction 300.

$$\sigma_S < \sigma_M + \sigma_I \qquad (2)$$

If this expression (2) is satisfied, a two-dimensional growth mode is achieved to grow a layer-by-layer film.

Silicon growth on SiC is dependent on the temperature of the substrate and the supply conditions of material atoms and is mostly governed by the expression (1). Growth of grains governed by the expression (1) will be explained. If the temperature of the substrate and the supply conditions of material atoms are fixed, a growth of grains in a substrate horizontal direction is dependent on the surface energy of the substrate. The larger the surface energy, the slower the grains grow in a substrate horizontal direction. On the other hand, the smaller the surface energy of the substrate, the faster the grains grow in the substrate horizontal direction.

Among $\alpha$-SiC crystal faces, the {0001-} crystal face 200 has the smallest surface energy that is about 1/7 of that of a {0001} crystal face used by the related art. (Refer to E. Pearson, T. Takai, T. Halicioglu, and W. A. Tiller, J. Cryst. Growth, 70, 33 (1984).)

According to the expression (2), the size of a silicon grain in a substrate horizontal direction on SiC will be the largest on the {0001-} crystal face 200 if the temperature of the substrate and the supply conditions of material atoms are fixed.

As a result, the energy band structure of the conduction band of the heterojunction 300 formed on the {0001-} crystal face 200 is substantially equal to that of Figs. 2A to 2C. Namely, without special processes or special equipment such as a laser annealing apparatus or an MBE apparatus, the first embodiment can provide a semiconductor device having required forward and reverse characteristics that correspond to the impurity concentration and conductivity type of the hetero-semiconductor region 103.

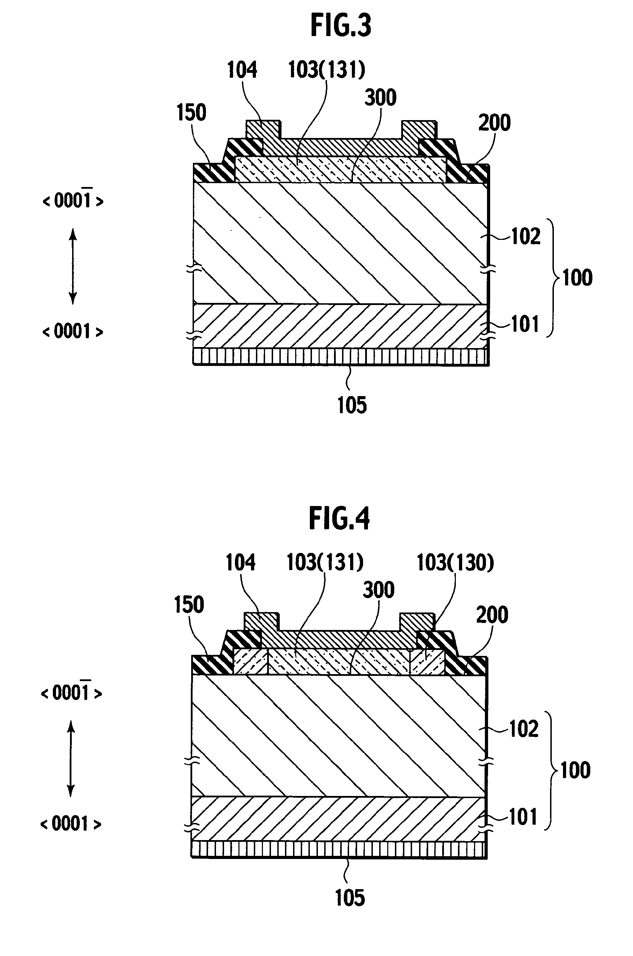

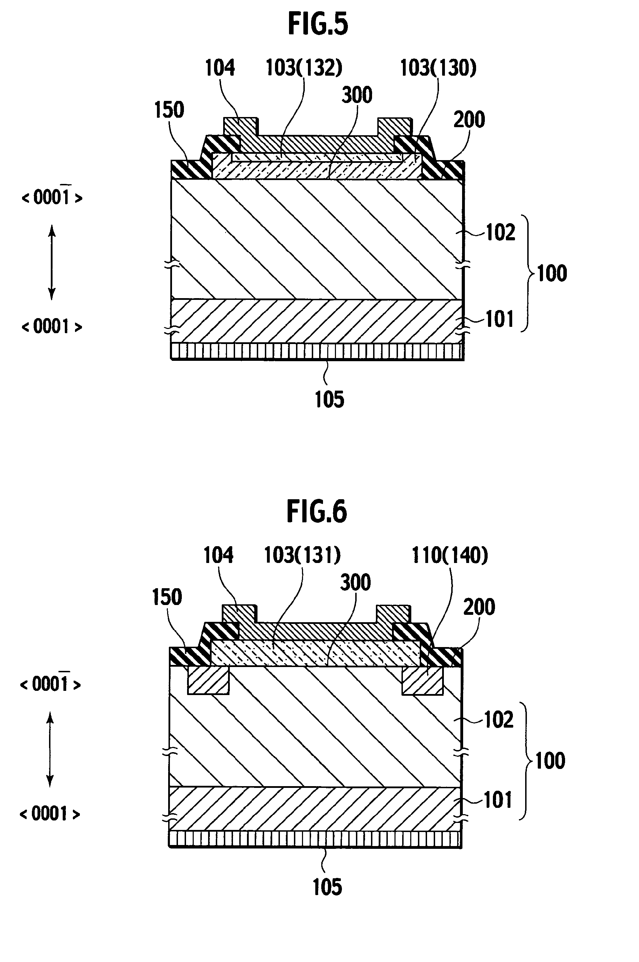

In Fig. 1, the silicon polycrystal film 130 that forms the hetero-semiconductor region 103 is of n-type (first conductivity type). Alternatively, the hetero-semiconductor region 103 may be formed from a p-type (second conductivity type) silicon polycrystal film 131 as shown in Fig. 3. It is also possible to form the hetero-semiconductor region 103 from silicon polycrystals having different conductivity types and impurity concentrations as shown in Figs. 4 and 5. In Fig. 5, a numeral 132 represents a high-concentration, n-type silicon polycrystal film.

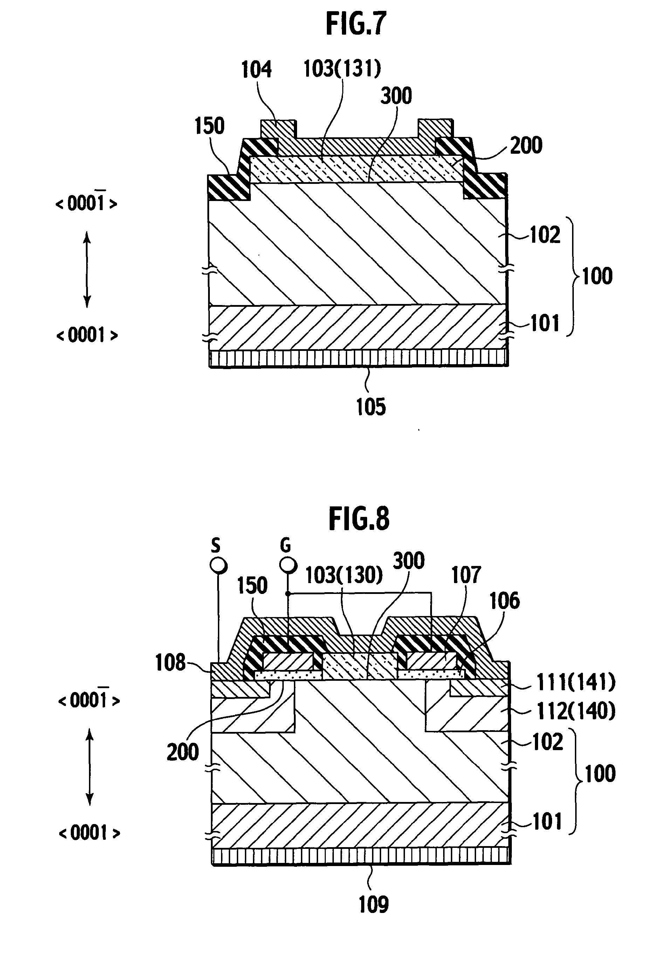

It is also possible to form an impurity introduced region 110 from a p-type SiC layer 140 in the SiC epitaxial layer 102 as shown in Fig. 6. It is also possible to employ a mesa structure as shown in Fig. 7. In Fig. 6, the impurity introduced region 110 is made from the p-type SiC layer 140. Instead, the region 110 may be made from a high-resistance dielectric.

As mentioned above, the semiconductor device according to the first embodiment includes the SiC semiconductor base 100 made of a first semiconductor material of a first conductivity type, the hetero-semiconductor region 103 formed on the semiconductor base 100 from a second semiconductor material that forms the heterojunction 300 and has a different band gap from the first semiconductor material, the cathode electrode 105 that is in contact with the semiconductor base 100, and the anode electrode 104 that is in contact with the hetero-semiconductor region 103. The first semiconductor material is an SiC single crystal, and the heterojunction 300 is formed on the {0001-} crystal face 200 of the SiC single crystal. The surface energy of the {0001-} crystal face 200 is the lowest among the SiC crystal faces and is about 1/7 of the surface energy of a {0001} crystal face that is used by the related art. As a result, without special processes or special equipment, the first embodiment can form the hetero-semiconductor region 103 composed of large grains on the {0001-} crystal face 200. Due to this, the semiconductor device of the first embodiment can realize desired forward and reverse characteristics based on the impurity concentration and conductivity type of the hetero-semiconductor region 103.

Second embodiment

Figure 8 is a sectional view showing a semiconductor device according to a second embodiment of the present invention. An n-type (first conductivity type) SiC substrate 101 and an n-type SiC epitaxial layer 102 whose impurity concentration is lower than that of the substrate 101 form an SiC semiconductor base 100. The SiC substrate 101 has, for example, a specific resistance of several to several hundreds of $m\Omega \cdot cm$ and a thickness of several tens to several hundreds of $\mu m$. The SiC epitaxial layer 102 has, for example, an impurity concentration of $1 \times 10^{15}$ to $1 \times 10^{19}$ cm$^{-3}$ and a thickness of several to several tens of $\mu m$. At a predetermined location in the SiC epitaxial layer 102, a base region 112 is formed from a p-type (second conductivity type) SiC layer 140. At a predetermined location in the SiC epitaxial layer 102, a source region 111 is formed from an n-type SiC layer 141. Adjacent to the SiC epitaxial layer 102, base region 112, and source region 111, a gate insulating film 106 and a gate electrode 107 are formed. In contact with a {0001-} crystal face 200 of the SiC epitaxial layer 102, a hetero-semiconductor region 103 is formed from an n-type silicon polycrystal film 130, to form a heterojunction 300 on the {0001-} crystal face 200. The heterojunction 300 forms an energy barrier. In contact with the source region 111 and hetero-semiconductor region 103, a source electrode 108 is formed. In contact with the SiC substrate 101, a drain electrode 109 is formed Although not shown in Fig. 8, the base region 112 is in contact with the source electrode 108 at a location behind Fig. 8.

The semiconductor device according to the second embodiment of Fig. 8 is formed by incorporating the semiconductor device of the first embodiment into a part of a power MOSFET that is a three-terminal semiconductor device. The semiconductor device of the first embodiment incorporated in the semiconductor device of the second embodiment can serve as a flywheel diode when the semiconductor device of the second embodiment is used in a reverse conductive state. A conventional power MOSFET employs, as a flywheel diode, a pn-junction diode (body diode) formed between a base region (112) and an SiC epitaxial layer (102). Since the pn-junction diode is a bipolar element, minority carriers may be injected into the SiC epitaxial layer (102) when the pn-junction diode serves as a flywheel diode. This results in increasing a reverse recovery current and a switching loss. On the other hand, the semiconductor device of the first embodiment is a unipolar element like a Schottky diode that causes no injection of minority carriers into the SiC epitaxial layer 102. This results in reducing a reverse recovery current and a switching loss.

Unlike the Schottky diode whose characteristics are uniquely determined by metal that forms the Schottky diode, the characteristics of the diode in the semiconductor device of the present invention can optionally be set according to the conductivity type and impurity concentration of the hetero-semiconductor region 103. Since the hetero-semiconductor region 103 of the present invention is made of not metal but semiconductor, it can be producible with usual processes.

Since the heterojunction 300 is formed on the {0001-} crystal face 200, required forward and reverse characteristics are obtainable based on the height of a barrier at the interface of the heterojunction 300 to provide the semiconductor device with high disconnection performance.

The three-terminal semiconductor device according to the second embodiment is a planar power MOSFET. The present invention is applicable to any other three-terminal semiconductor devices. For example, a trench power MOSFET or JFET may incorporate the semiconductor device of the first embodiment, to realize a semiconductor device having a high disconnection ability and a low switching loss.

As mentioned above, the three-terminal semiconductor device according to the second embodiment includes a drain region formed in the semiconductor base 100 made of a first semiconductor material of a first conductivity type, the base region 112 of a second conductivity type, the source region 111 of the first conductivity type, the source electrode 108 formed in contact with the source region 111, the drain electrode 109 formed in contact with the drain region, and the hetero-semiconductor region 103 made of a second semiconductor material that forms a heterojunction with the drain region, has a different band gap from the first semiconductor material, and is in contact with the source electrode 108. The first semiconductor material is an SiC single crystal, and the heterojunction 300 is formed on the {0001-} crystal face 200 of the SiC single crystal. In this way, at least a part of the semiconductor device of the second embodiment having three or more terminals incorporates the structure of the first embodiment The part having the structure of the first embodiment demonstrates a reverse characteristic depending on the impurity concentration and conductivity type of the hetero-semiconductor region 103. Due to this, the semiconductor device of the second embodiment realizes a high disconnection capability. In addition, the part incorporating the structure of the first embodiment can be used as a flywheel diode when the semiconductor device of the second embodiment is used in a reverse conductive state. In this case, the flywheel diode is a unipolar element, and therefore, causes no injection of minority carriers into the drain region unlike a pn-junction diode incorporated in, for example, a conventional power MOSFET. Accordingly, the semiconductor device of the second embodiment can reduce a switching power loss.

Third embodiment

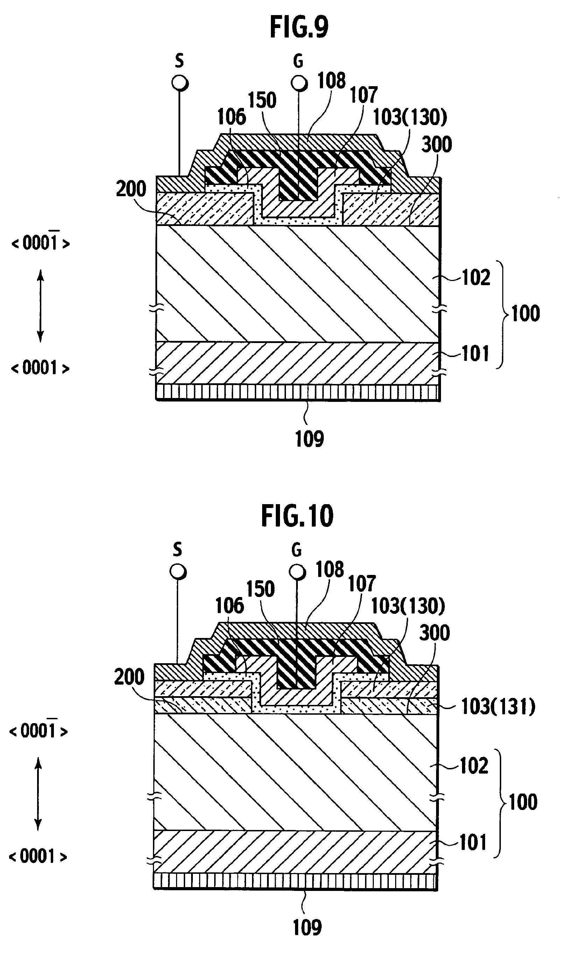

Figure 9 is a sectional view showing a semiconductor device according to a third embodiment of the present invention. An n-type SiC substrate 101 and an n-type SiC epitaxial layer 102 whose impurity concentration is lower than that of the substrate 101 form an SiC semiconductor base 100. The SiC substrate 101 has, for example, a specific resistance of several to several hundreds of mΩ·cm and a thickness of several tens to several hundreds of μ m. The SiC epitaxial layer 102 has, for example, an impurity concentration of $1 \times 10^{15}$ to $1 \times 10^{19}$ cm$^{-3}$ and a thickness of several to several tens of μm. On the SiC epitaxial layer 102, a hetero-semiconductor region 103 is formed from an n-type silicon polycrystal film 130 that is a second semiconductor material to form a heterojunction 300 with SiC and having a different band gap from SiC. The heterojunction 300 is formed on a {0001-} crystal face 200 of the SiC semiconductor base 100. At an interface of the heterojunction 300, an energy barrier is present. Adjacent to the heterojunction 300, there are a gate insulating film 106 and a gate electrode 107. An interlayer dielectric 150 is formed to cover the gate electrode 107. In contact with the hetero-semiconductor region 103, a source electrode 108 is formed. In contact with the SiC semiconductor base 100, a drain electrode 109 is formed.

Operation of the semiconductor device according to the third embodiment will be explained. For example, the source electrode 108 is grounded, a positive potential is applied to the drain electrode 109, and a ground potential or a negative potential is applied to the gate electrode 107. Then, the interface of the heterojunction 300 that is formed on the {0001-} crystal face 200 between the silicon polycrystal hetero-semiconductor region 103 and the SiC epitaxial layer 102 forms an energy barrier against conductive electrons. As a result, no current flows between the source electrode 108 and the drain electrode 109, to establish a nonconductive state.

When a positive potential is applied to the gate electrode 107 to switch the nonconductive state to a conductive state, a gate electric field extends through the gate insulating film 106 to the interface of the heterojunction 300 formed on the {0001-} crystal face 200 between the silicon polycrystal hetero-semiconductor region 103 and the SiC epitaxial layer 102. As a result, the hetero-semiconductor region 103 and epitaxial layer 102 adjacent to the gate electrode 107 form an electron accumulation layer. Namely, the potential of the interface of the heterojunction 300 on the hetero-semiconductor region 103 side decreases, and the energy barrier on the epitaxial layer 102 side becomes steeper. As a result, electrons tunnel through the energy barrier.

When a ground potential or a negative potential is again applied to the gate electrode 107 to switch the conductive state to a nonconductive state, the electron accumulated state of the interface of the heterojunction 300, which is formed on the {0001-} crystal face 200 between the silicon polycrystal hetero-semiconductor region 103 and the SiC epitaxial layer 102, is released to stop the tunneling of electrons through the energy barrier. A flow of electrons from the silicon polycrystal hetero-semiconductor region 103 to the SiC epitaxial layer 102 stops, and electrons in the SiC epitaxial layer 102 flow to the SiC substrate 101 and deplete. Then, a depletion layer extends from the heterojunction 300 to the SiC epitaxial layer 102, to establish a nonconductive state. In this way, the semiconductor device of the third embodiment performs a switching operation.

The height of the barrier formed in the heterojunction 300 between the hetero-semiconductor region 103 and the SiC epitaxial layer 102 changes according to an electric field from the gate electrode 107, to realize the switching operation. Namely, the semiconductor device of the third embodiment has no channel region that is usually present in, for example, a MOS (metal oxide semiconductor) field effect transistor, and therefore, involves no voltage drop in the channel region. Due to this, the semiconductor device of the third embodiment can reduce ON-resistance. The third embodiment forms the hetero-semiconductor region 103 on the {0001-} crystal face 200 to form the heterojunction 300, so that required driving force and reverse characteristic are easily obtained according to the height of a barrier at the interface of the heterojunction 300. Unlike a generally-used {0001} crystal face, the {0001-} crystal face 200 has an oxidation speed equivalent to a silicon oxidation speed. Therefore, the gate insulating film 106, hetero-semiconductor region 103, and SiC epitaxial layer 102 may simultaneously be formed by thermal oxidation. This improves the reliability of the gate insulating film 106 compared with the related art.

Like the semiconductor device of the first embodiment, the semiconductor device of the third embodiment involves a diode served with the source electrode 108 as an anode electrode (104) and the drain electrode 109 as a cathode electrode (105), to eliminate a flywheel diode in a reverse conductive operation. This results in reducing a chip area and ON-resistance.

This diode of the third embodiment is a unipolar element as mentioned above, and unlike a pn-junction diode, causes no injection of minority carriers into the SiC epitaxial layer 102. This results in reducing a reverse recovery current and a switching power loss.

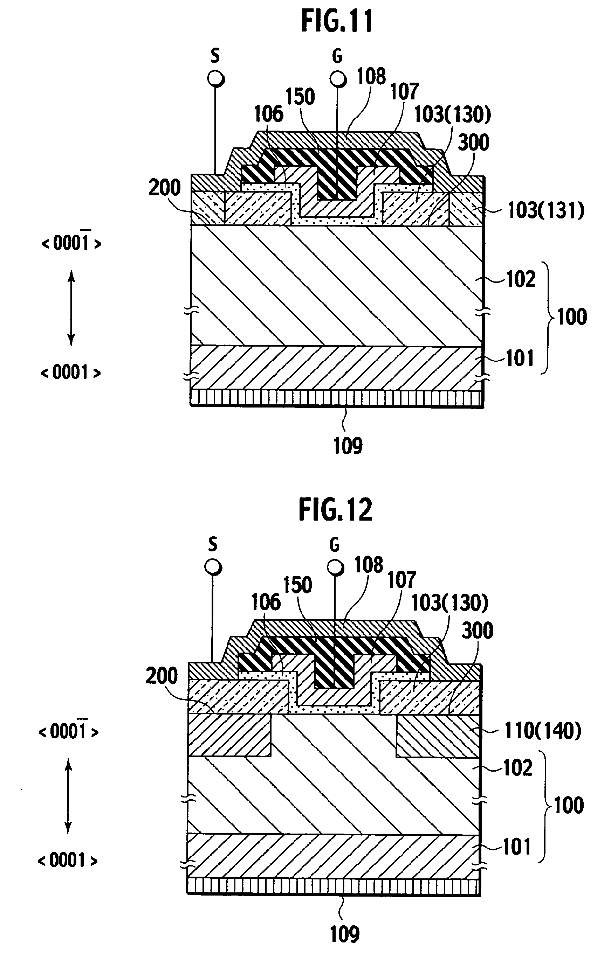

In Fig. 9, the semiconductor device of the third embodiment is a cumulative transistor with the hetero-semiconductor region 103 made from the n-type silicon polycrystal film 130. The hetero-semiconductor region 103 of the semiconductor device of the third embodiment may be made of a silicon polycrystal having a different conductivity type and a different impurity concentration. For example, as shown in Fig. 10, a p-type silicon polycrystal film 131 and an n-type silicon polycrystal film 130 may be layered to form an inverted transistor. As shown in Fig. 11, different conductivity types and different impurity concentrations may be arranged in the same plane.

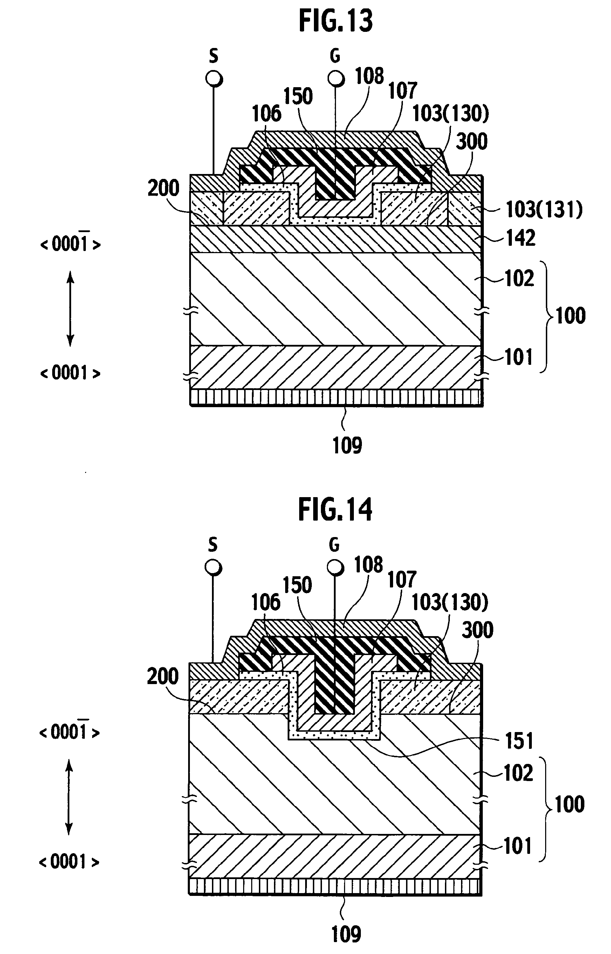

As shown in Fig. 12, in addition to the structure of Fig. 9, the SiC epitaxial layer 102 may include an impurity introduced region 110 made from a p-type (second conductivity type) SiC layer 140. As shown in Fig. 13, an n-type (first conductivity type) SiC buffer layer 142 may be formed between the {0001-} crystal face 200 of the SiC epitaxial layer 102 and the hetero-semiconductor region 103. The impurity concentration of the buffer layer 142 is higher than that of the epitaxial layer 102 and the conductivity type thereof is the same as that of the epitaxial layer 102. In Fig. 12, the impurity introduced region 110 is made from the p-type SiC layer 140. Instead, the region 110 may be made from a high-resistance dielectric.

As mentioned above, the semiconductor device according to the third embodiment includes the semiconductor base 100 made of a first semiconductor material of a first conductivity type, the hetero-semiconductor region 103 made of a second semiconductor material having a different band gap from the first semiconductor material, to form a heterojunction on the semiconductor base 100, the gate electrode 107 formed on the gate insulating film 106 adjacent to the junction between the semiconductor base 100 and the hetero-semiconductor region 103, the source electrode 108 formed in contact with the hetero-semiconductor region 103, and the drain electrode 109 formed in contact with the semiconductor base 100. The first semiconductor material is an SiC single crystal, and the heterojunction 300 is formed on the {0001-} crystal face of the SiC single crystal. The height of a barrier at the interface of the heterojunction 300 between the hetero-semiconductor region 103 and the SiC epitaxial layer 102 changes according to a gate electric field from the insulated gate 107 to realize a switching operation. The hetero-semiconductor region 103 formed on the {0001-} crystal face to form the heterojunction 300 includes large grains to improve the quality of the heterojunction 300. As a result, desired driving force and reverse characteristic are easily obtained according to the height of the barrier at the interface of the heterojunction 300. An oxidation speed on the {0001-} crystal face is substantially equal to an oxidation speed of silicon, and therefore, the gate insulating film 106 may be made from a thermal oxidation film. If no gate electric field is applied, the semiconductor device of the third embodiment functions as a diode, like the semiconductor device of the first embodiment, with the source electrode 108 serving as an anode electrode (104) and the drain electrode 109 as a cathode electrode (105). This eliminates a flywheel diode during a reverse conduction operation. This may reduce a chip area and ON-resistance. This diode of the third embodiment is a unipolar element as mentioned above to cause no injection of minority carriers into the SiC epitaxial layer 102 unlike a pn-junction diode. Consequently, the third embodiment can reduce a switching power loss.

Fourth embodiment

Figure 14 is a sectional view showing a semiconductor device according to a fourth embodiment of the present invention. An n-type SiC substrate 101 and an n-type SiC epitaxial layer 102 whose impurity concentration is lower than that of the substrate 101 form an SiC semiconductor base 100. The SiC substrate 101 has, for example, a specific resistance of several to several hundreds of $m\Omega\cdot cm$ and a thickness of several tens to several hundreds of $\mu m$. The SiC epitaxial layer 102 has, for example, an impurity concentration of $1 \times 10^{15}$ to $1 \times 10^{19}$ $cm^{-3}$ and a thickness of several to several tens of $\mu m$. On the SiC epitaxial layer 102, a hetero-semiconductor region 103 is formed from an n-type silicon polycrystal film 130 that is a second semiconductor material to form a heterojunction 300 with SiC and having a different band gap from SiC. The heterojunction 300 is formed on a {0001-} crystal face 200 of the SiC semiconductor base 100. At an interface of the heterojunction 300, an energy barrier is present.

A trench 151 is formed through the hetero-semiconductor region 103, to reach the SiC epitaxial layer 102. A gate insulating film 106 and a gate electrode 107 are formed on side walls of the trench 151 and adjacent to the heterojunction 300. In contact with the hetero-semiconductor region 103, a source electrode 108 is formed. In contact with the SiC semiconductor base 100, a drain electrode 109 is formed.

In this way, the semiconductor device according to the fourth embodiment includes the semiconductor base 100 made of a first semiconductor material of a first conductivity type, the hetero-semiconductor region 103 made of a second semiconductor material whose band gap differs from that of the first semiconductor material, to form a heterojunction on the semiconductor base 100, the trench 151 formed through the hetero-semiconductor region 103 to reach the semiconductor base 100, the gate insulating film 106 and gate electrode 107 formed in the trench 151, the source electrode 108 formed in contact with the hetero-semiconductor region 103, and the drain electrode 109 formed in contact with the semiconductor base 100. The first semiconductor material is an SiC single crystal, and the heterojunction is formed on the {0001-} crystal face 200 of the SiC single crystal.

In addition to the effect of the semiconductor device of the third embodiment, the semiconductor device of the fourth embodiment provides an effect of reducing an area per cell due to the trench structure, an effect of improving cell integration, and an effect of reducing ON-resistance.

The first to fourth embodiments mentioned above relate to vertical semiconductor devices that vertically pass a current The present invention is also applicable to horizontal semiconductor devices that horizontally pass a current.

The first to fourth embodiments employ a silicon polycrystal to form the hetero-semiconductor region 103. According to the present invention, the hetero-semiconductor region 103 may be made of any other semiconductor material if the material's band gap differs from that of SiC. For example, the hetero-semiconductor region 103 may be made of silicon germanium, or germanium. If the second semiconductor material used to form the hetero-semiconductor region 103 is a widely available material such as a silicon single crystal or a silicon polycrystal, it will easily be produced through usual manufacturing processes.

In the first to fourth embodiments, the first conductivity type is "n" and the second conductivity type is "p." Instead, the first conductivity type may be "p" and the second conductivity type may be "n," to provide the effects of the present invention.

The entire contents of Japanese patent application P2004-117567 filed on April thirteenth, 2004 are hereby incorporated by reference.

The invention may be embodied in other specific forms without departing from the spirit or essential characteristics thereof. The present embodiment is therefore to be considered in all respects as illustrative and not restrictive, the scope of the invention being indicated by the appended claims rather than by the foregoing description, and all changes which come within the meaning and range of equivalency of the claims are therefore intended to be embraced therein.

## Claims

1. A semiconductor device comprising:

   a semiconductor base essentially made of a first semiconductor material of a first conductivity type;
   a hetero-semiconductor region essentially made of a second semiconductor material whose band gap is different from that of the first semiconductor material, formed on the semiconductor base, and forming a heterojunction with the semiconductor base;
   a cathode electrode formed in contact with the semiconductor base; and
   an anode electrode formed in contact with the hetero-semiconductor region,

   wherein the first semiconductor material is a silicon-carbide (SiC) single crystal and the heterojunction is formed on a {0001-} crystal face of the silicon-carbide single crystal.

2. A semiconductor device comprising:

   a drain region formed from a semiconductor base made of a first semiconductor material of a first conductivity type;
   a base region of a second conductivity type, base region in contact with the drain region;
   a source region of the first conductivity type, the source region in contact with the base region;
   a source electrode formed in contact with the source region and the base region;
   a drain electrode formed in contact with the drain region; and
   a hetero-semiconductor region made of a second semiconductor material that has a different band gap from the first semiconductor material, forms a heterojunction with the drain region, and is in contact with the source electrode, wherein:

      the first semiconductor material is a silicon-carbide single crystal and the heterojunction is formed on a {0001-} crystal face of the silicon-carbide single crystal.

3. A semiconductor device comprising:

   a semiconductor base essentially made of a first semiconductor material of a first conductivity type;
   a hetero-semiconductor region formed on the semiconductor base and essentially made of a second semiconductor material that has a different band gap from the first semiconductor material and forms a heterojunction with the semiconductor base;

a gate electrode formed on a gate insulating film adjacent to the heterojunction between the semiconductor base and the hetero-semiconductor region;

a source electrode formed in contact with the hetero-semiconductor region; and

a drain electrode formed in contact with the semiconductor base, wherein:

> the first semiconductor material is a silicon-carbide single crystal and the heterojunction is formed on a {0001-} crystal face of the silicon-carbide single crystal.

4. A semiconductor device comprising:

> a semiconductor base made of a first semiconductor material of a first conductivity type;
> a hetero-semiconductor region formed on the semiconductor base and made of a second semiconductor material that has a different band gap from the first semiconductor material and forms a heterojunction with the semiconductor base;
> a trench formed through the hetero-semiconductor region to reach the semiconductor base;
> a gate electrode formed on a gate insulating film in the trench;
> a source electrode formed in contact with the hetero-semiconductor region; and
> a drain electrode formed in contact with the semiconductor base, wherein;
> the first semiconductor material is a silicon-carbide single crystal and the heterojunction is formed on a {0001-} crystal face of the silicon-carbide single crystal.

5. The semiconductor device as claimed in claim 1, 2, 3, or 4, wherein the hetero-semiconductor region is of the first conductivity type.

6. The semiconductor device as claimed in claim 1, 2, 3, or 4, further comprising:

> a second hetero-semiconductor region essentially made of the second semiconductor material whose band gap is different from that of the first semiconductor material, the second hetero-semiconductor region being formed on the semiconductor base and forming a heterojunction with the semiconductor base.

7. The semiconductor device as claimed in claim 1, 2, 3, or 4, further comprising: a second hetero-semiconductor region essentially made of the second semiconductor material whose band gap is different from that of the first semiconductor material, the second hetero-semiconductor region being formed on the hetero-semiconductor region and having a higher impurity concentration than the hetero-semiconductor region.

8. The semiconductor device as claimed in claim 1, 2, 3, or 4, further comprising: an impurity introduced region essentially made of silicon carbide of a second conductivity type and formed in a part of the surface of the semiconductor base.

9. The semiconductor device as claimed in claim 1, 2, 3, or 4, wherein the semiconductor device has a mesa structure.

10. The semiconductor device as claimed in claim 1, 2, 3, or 4, wherein:

> the second semiconductor material is selected from the group consisting of a silicon single crystal and a silicon polycrystal.

# FIG.1

FIG.2A

FIG.2B

FIG.2C

# FIG.3

# FIG.4

# FIG.5

104   103(132)   103(130)

150   300   200

< 0001̄ >

< 0001 >

102
100
101

105

# FIG.6

104   103(131)   110(140)

150   300   200

< 0001̄ >

< 0001 >

102
100
101

105

# FIG.7

104  103(131)  300

150  200

< 0001̄ >

102

100

< 0001 >  101

105

# FIG.8

S  G

150  103(130)  300  107  106

108

111(141)

< 0001̄ >

112(140)

200  102

100

< 0001 >  101

109

# FIG.9

S  G  108

106  150  107

103(130)

300

200

< 0001̄ >

< 0001 >

102

100

101

109

# FIG.10

S  G  108

106  150  107

103(130)

300

200

103(131)

< 0001̄ >

< 0001 >

102

100

101

109

# FIG.11

S  G

106  150  108  107  103(130)

200  300

103(131)

< 0001̅ >

< 0001 >

102  100

101

109

# FIG.12

S  G

106  150  108  107  103(130)

200  300

110(140)

< 0001̅ >

< 0001 >

102  100

101

109

# FIG.13

S  G  108  107  103(130)
106  150  300
200  103(131)
< 0001̄ >  142
102  100
< 0001 >  101
109

# FIG.14

S  G  108  107  103(130)
106  150  300
200
< 0001̄ >  151
102  100
< 0001 >  101
109